# EUROPEAN PATENT SPECIFICATION

(11) **EP 3 930 122 B1**
(45) Date of publication and mention of the grant of the patent: **30.10.2024**
(21) Application number: 20760005.7
(22) Date of filing: 05.02.2020
(51) Int. Cl.: H01S 5/183, H01S 5/20

(54) **VERTICAL RESONATOR-TYPE LIGHT-EMITTING DEVICE**
LICHTEMITTIERENDE VORRICHTUNG VOM VERTIKALRESONATORTYP
DISPOSITIF ÉLECTROLUMINESCENT DU TYPE À RÉSONATEUR VERTICAL

(30) Priority: 21.02.2019 JP 2019029294
(43) Date of publication of application: 29.12.2021
(73) Proprietor: STANLEY ELECTRIC CO., LTD., Tokyo 153-8636 (JP)
(72) Inventor: KURAMOTO, Masaru, Tokyo 153-8636 (JP); KOBAYASHI, Seiichiro, Tokyo 153-8636 (JP)
(74) Representative: Klang, Alexander H.
(86) International application number: PCT/JP2020/004314
(87) International publication number: WO 2020/170818

(56) References cited:
- EP-A1- 0 944 142
- EP-A1- 3 869 643
- EP-A2- 1 811 620
- WO-A1-2007/116659
- JP-A- 2013 175 712
- JP-A- 2019 208 004
- JP-A- H0 918 084
- JP-A- H04 363 081
- US-A1- 2008 279 241

## Description

### TECHNICAL FIELD

The present invention relates to a vertical cavity surface emitting device, such as a vertical cavity surface emitting laser.

### BACKGROUND ART

The vertical cavity surface emitting laser (hereinafter simply referred to as a surface emitting laser) is a semiconductor laser that includes reflecting mirrors formed of multilayer films stacked on a substrate and emits a light in a direction perpendicular to a surface of the substrate. For example, JP 5 707 742 B P discloses a surface emitting laser using a nitride semiconductor.

EP 1 811 620 A discloses a surface-emitting type semiconductor laser which includes: a first mirror; an active layer formed above the first mirror; a second mirror formed above the active layer; and a current constricting section formed above or below the active layer, wherein the second mirror has a plurality of concave sections arranged within a plane perpendicular to a light emission direction, and a light confining region surrounded by the concave sections is formed inside a region surrounded by the current constricting section as viewed in a plan view.

JP H04 363081 A discloses a surface emitting semiconductor laser which emits light in a direction perpendicular to a semiconductor substrate, the surface emitting semiconductor laser includes a pair of reflecting mirrors having different reflectivities and a multilayer semiconductor layer therebetween, and at least a cladding layer among the semiconductor layers is formed. A surface-emitting type semiconductor laser includes: one or a plurality of columnar optical resonators; and a II-VI compound semiconductor epitaxial layer embedded around the columnar semiconductor layer.

EP 0 944 142 A discloses a surface-emitting laser. Transverse modes are controlled and phase-synchronized laser beams are emitted from a plurality of light-emitting portions to produce what appears to be a single laser beam. This laser includes a columnar portion forming part of a reflective mirror on a light-emitting side, an embedding layer surrounding the periphery of the columnar portion, an upper electrode formed on the columnar portion and the embedding layer, and an insulating layer formed below the columnar portion and the embedding layer. A plurality of aperture portions are formed in the upper electrode above the columnar portion, and aperture portions are formed in the insulation layer at positions corresponding to the aperture portions. The absolute refractive index of the embedding layer is slightly smaller than that of the columnar portion, so that the transverse modes are controlled thereby.

US 2008 279241 A discloses a light-emitting element includes a mesa structure in which a first compound semiconductor layer of a first conductivity type, an active layer, and a second compound semiconductor layer of a second conductivity type are disposed in that order, wherein at least one of the first compound semiconductor layer and the second compound semiconductor layer has a current constriction region surrounded by an insulation region extending inward from a sidewall portion of the mesa structure; a wall structure disposed so as to surround the mesa structure; at least one bridge structure connecting the mesa structure and the wall structure, the wall structure and the bridge structure each having the same layer structure as the portion of the mesa structure in which the insulation region is provided; a first electrode; and a second electrode disposed on a top face of the wall structure.

### DISCLOSURE OF THE INVENTION

### PROBLEMS TO BE SOLVED BY THE INVENTION

For example, in the vertical cavity surface emitting device, such as the surface emitting laser, it is preferred that a light emission pattern is stable, for example, a far-field pattern is stable. Accordingly, for example, a resonator configured to generate a light in a desired transverse mode is preferably configured in the vertical cavity surface emitting device. For example, generating a laser beam in a fundamental eigenmode allows obtaining a far-field pattern of unimodal laser beam having a low emission angle and a high-output power.

The present invention has been made in consideration of the above-described points and an object of which is to provide a vertical cavity surface emitting device that allows emitting a light in a stable transverse mode.

### SOLUTIONS TO THE PROBLEMS

In accordance with the present invention, a vertical cavity surface emitting device as set forth in the appended claims is provided. In particular, a vertical cavity surface emitting device according to the present invention includes a substrate, a first multilayer film reflecting mirror, a light-emitting structure layer, and a second multilayer film reflecting mirror. The first multilayer film reflecting mirror is formed on the substrate. The light-emitting structure layer is formed on the first multilayer film reflecting mirror. The light-emitting structure layer includes a light-emitting layer. The second multilayer film reflecting mirror is formed on the light-emitting structure layer. The second multilayer film reflecting mirror constitutes a resonator between the first multilayer film reflecting mirror and the second multilayer film reflecting mirror. The light-emitting structure layer has a high resistance region and a low resistance region having an electrical resistance lower than an electrical resistance of the high resistance region. The low resistance region has a plurality of partial regions arranged into a ring shape while being separated by the high resistance region in a plane of the light-emitting structure layer.

### BRIEF DESCRIPTION OF THE DRAWINGS

FIG. 1 is a schematic top view of a surface emitting laser according to Embodiment 1.
FIG. 2 is a cross-sectional view of the surface emitting laser according to Embodiment 1.
FIG. 3 is a top view of a high resistance region and a low resistance region in the surface emission laser according to Embodiment 1.
FIG. 4 is a drawing schematically illustrating an optical property of the surface emission laser according to Embodiment 1.
FIG. 5 is a drawing schematically illustrating an electrical property of the surface emission laser according to Embodiment 1.
FIG. 6 is a drawing schematically illustrating an aspect of a light emitted from the surface emission laser according to Embodiment 1.
FIG. 7A is a drawing illustrating a near-field pattern of the surface emission laser according to Embodiment 1.
FIG. 7B is a drawing illustrating a far-field pattern of the surface emission laser according to Embodiment 1.
FIG. 7C is a drawing illustrating a wavelength property of the surface emission laser according to Embodiment 1.
FIG. 8 is a top view of a high resistance region and a low resistance region in the surface emission laser according to Modification 1 of Embodiment 1.
FIG. 9 is a cross-sectional view of the surface emission laser according to Modification 1 of Embodiment 1.
FIG. 10 is a top view of a high resistance region and a low resistance region in a surface emission laser according to Modification 2 in Embodiment 1.
FIG. 11 is a top view of a high resistance region and a low resistance region in a surface emission laser according to Modification 3 in Embodiment 1.
FIG. 12 is a top view of a high resistance region and a low resistance region in a surface emission laser according to Embodiment 2.
FIG. 13 is a cross-sectional view of a surface emission laser according to Embodiment 3.
FIG. 14 is a cross-sectional view of a surface emission laser according to a modification of Embodiment 3.
FIG. 15 is a cross-sectional view of a surface emission laser according to Embodiment 4.
FIG. 16 is a cross-sectional view of a surface emission laser according to Embodiment 5.

### DESCRIPTION OF PREFERRED EMBODIMENTS

The following will describe embodiments of the present invention in detail. In the following embodiments, a case where the present invention is embodied as a surface emitting laser (semiconductor laser) will be described. However, the present invention is not limited to the surface emitting laser but applicable to various kinds of vertical cavity surface emitting devices, such as a vertical cavity surface emitting diode.

### Embodiment 1

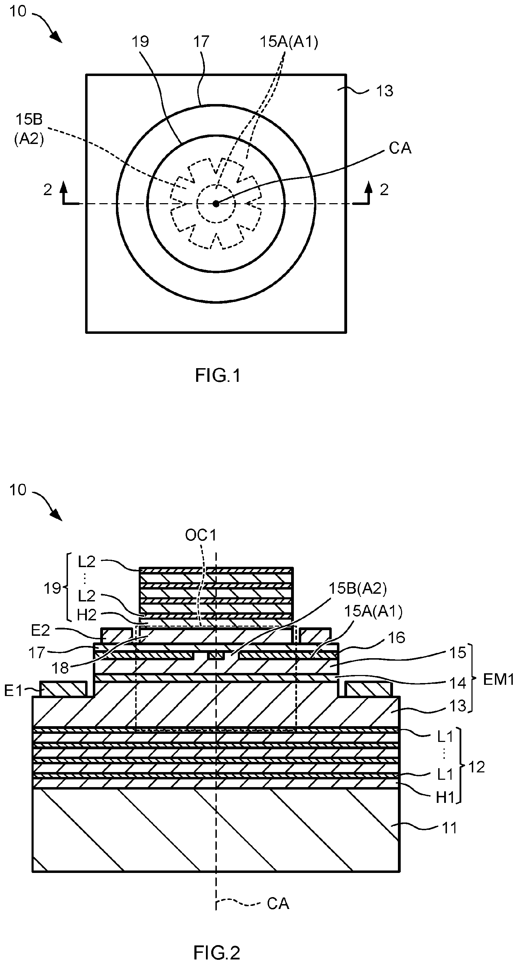

FIG. 1 is a schematic top view of a Vertical Cavity Surface Emitting Laser (VCSEL, hereinafter referred to as a surface emitting laser) according to Embodiment 1. FIG. 2 is a cross-sectional view of a surface emitting laser 10. FIG. 2 is a cross-sectional view taken along the line 2-2 in FIG. 1. The configuration of the surface emitting laser 10 will be described with reference to FIG. 1 and FIG. 2.

The surface emitting laser 10 includes a substrate 11 and a first multilayer film reflecting mirror (hereinafter simply referred to as a first reflecting mirror) 12 formed on the substrate 11. In this embodiment, the first reflecting mirror 12 is formed on the substrate 11 and has a structure in which first semiconductor films (hereinafter referred to as high refractive index semiconductor films) H1 and second semiconductor films (hereinafter referred to as low refractive index semiconductor films) L1 having a refractive index lower than that of the high refractive index semiconductor film H1 are stacked in alternation. In this embodiment, the first reflecting mirror 12 constitutes a Distributed Bragg Reflector (DBR) made of a semiconductor material.

In this embodiment, the substrate 11 has a composition of GaN. The substrate 11 is a substrate for growth used for crystal growth of the first reflecting mirror 12. The high refractive index semiconductor film H1 in the first reflecting mirror 12 has a composition of GaN, and the low refractive index semiconductor film L1 has a composition of AlInN. In this embodiment, between the substrate 11 and the first reflecting mirror 12, a buffer layer (not illustrated) having a composition of GaN is disposed.

The surface emitting laser 10 includes a light-emitting structure layer EM1 formed on the first reflecting mirror 12 and including a light-emitting layer 14. In this embodiment, the light-emitting structure layer EM1 includes a plurality of semiconductor layers made of a nitride-based semiconductor. The light-emitting structure layer EM1 includes an n-type semiconductor layer (first semiconductor layer) 13 formed on the first reflecting mirror 12, the light-emitting layer (active layer) 14 formed on the n-type semiconductor layer 13, and a p-type semiconductor layer (second semiconductor layer) 15 formed on the light-emitting layer 14.

In this embodiment, the n-type semiconductor layer 13 has a composition of GaN and contains Si as n-type impurities. The light-emitting layer 14 has a quantum well structure that includes a well layer having a composition of InGaN and a barrier layer having a composition of GaN. The p-type semiconductor layer 15 has a GaN-based composition and contains Mg as p-type impurities.

The configuration of the light-emitting structure layer EM1 is not limited to this. For example, the n-type semiconductor layer 13 may include a plurality of n-type semiconductor layers having mutually different compositions. The p-type semiconductor layer 15 may include a plurality of p-type semiconductor layers having mutually different compositions.

For example, the p-type semiconductor layer 15 may include, for example, an AlGaN layer as an electron-blocking layer (not illustrated) that reduces an overflow of electrons implanted into the light-emitting layer 14 to the p-type semiconductor layer 15 at the interface with the light-emitting layer 14. The p-type semiconductor layer 15 may include a contact layer (not illustrated) to form an ohmic contact with an electrode. In this case, for example, the p-type semiconductor layer 15 only needs to include a GaN layer as a cladding layer between the electron-blocking layer and the contact layer.

In this embodiment, the p-type semiconductor layer 15 has an upper surface 15A and a projection 15B projecting from the upper surface 15A. In this embodiment, the projection 15B has an approximately circular ring shape having a side surface including a radial projection when viewed in a direction perpendicular to the upper surface 15A.

The surface emission laser 10 has an insulating layer (a first insulating layer) 16 formed on the upper surface 15A other than the projection 15B of the p-type semiconductor layer 15. In this embodiment, the insulating layer 16 is in contact with the upper surface 15A of the p-type semiconductor layer 15 and a side surface of the projection 15B of the p-type semiconductor layer 15. The insulating layer 16 has translucency to a light emitted from the light-emitting layer 14 and is made of a material having a refractive index lower than that of the p-type semiconductor layer 15 (the projection 15B), for example, an oxide, such as SiO₂. The p-type semiconductor layer 15 has a surface on the opposite side of the light-emitting layer 14 that is exposed from the insulating layer 16 on a top end surface of the projection 15B.

The surface emitting laser 10 includes a light-transmitting electrode layer 17 formed on the insulating layer 16 and connected to the p-type semiconductor layer 15 in the projection 15B of the p-type semiconductor layer 15. The light-transmitting electrode layer 17 is a conductive film having translucency to a light emitted from the light-emitting layer 14. The light-transmitting electrode layer 17 is in contact with the upper surface of the insulating layer 16 and the upper end surface of the projection 15B of the p-type semiconductor layer 15. For example, the light-transmitting electrode layer 17 is made of a metal oxide film, such as ITO or IZO.

The insulating layer 16 functions as a current confinement layer that confines a current injected into the light-emitting structure layer EM1 via the light-transmitting electrode layer 17. First, regions outside the projection 15B in the p-type semiconductor layer 15 (regions of the upper surface 15A) function as high resistance regions A1 having a high electrical resistance by being covered with the insulating layer 16. The projection 15B of the p-type semiconductor layer 15 is exposed from the insulating layer 16 and is in contact with the light-transmitting electrode layer 17 (electrode) to function as a low resistance region A2 having an electrical resistance lower than that of the high resistance region A1 in the light-emitting structure layer EM 1.

The region of the upper surface 15A of the p-type semiconductor layer 15 functions as a non-current injection region from which the injection of the current to the light-emitting layer 14 is suppressed. Then, the region where the projection 15B of the p-type semiconductor layer 15 is disposed functions as a current injection region from which the confined current is injected to the light-emitting layer 14.

The surface emitting laser 10 includes an insulating layer (a second insulating layer) 18 formed on the light-transmitting electrode layer 17. For example, the insulating layer 18 is made of a metal oxide with insulation property, such as Ta₂O₅, Nb₂O₅, ZrO₂, TiO₂, and HfO₂. The insulating layer 18 has translucency to the light emitted from the light-emitting layer 14.

The surface emitting laser 10 includes the second multilayer film reflecting mirror (hereinafter simply referred to as the second reflecting mirror) 19 formed on the insulating layer 18. The second reflecting mirror 19 is disposed at a position facing the first reflecting mirror 12 with the light-emitting structure layer EM1 interposed therebetween. A resonator OC1 having a direction perpendicular to the light-emitting structure layer EM1 (a direction perpendicular to the substrate 11) as a resonator length direction is constituted between the second reflecting mirror 19 and the first reflecting mirror 12.

In this embodiment, the second reflecting mirror 19 has a structure in which first dielectric films (hereinafter referred to as high refractive index dielectric films) H2 and second dielectric films (hereinafter referred to as low refractive index dielectric films) L2 having a refractive index lower than that of the high refractive index dielectric films H2 are stacked in alternation.

That is, in this embodiment, the second reflecting mirror 19 constitutes the Distributed Bragg Reflector (DBR) made of a dielectric material. For example, in this embodiment, the high refractive index dielectric film H2 is made of a Ta₂O₅ layer, and the low refractive index dielectric film L2 is made of an Al₂O₃ layer.

In this embodiment, as illustrated in FIG. 1, the second reflecting mirror 19 has a shape of a column shape. Accordingly, in this embodiment, the surface emission laser 10 has the resonator OC1 in a column shape.

The surface emitting laser 10 includes first and second electrodes E1 and E2 that apply a current to the light-emitting structure layer EM1. The first electrode E1 is formed on the n-type semiconductor layer 13. The second electrode E2 is formed on the light-transmitting electrode layer 17.

The application of a voltage between the first and the second electrodes E1 and E2 emits the light from the light-emitting layer 14 in the light-emitting structure layer EM1. The light emitted from the light-emitting layer 14 repeats reflection between the first and the second reflecting mirrors 12 and 19, thus entering a resonance state (performing laser oscillation).

In this embodiment, the first reflecting mirror 12 has reflectance slightly lower than that of the second reflecting mirror 19. Therefore, a part of the light resonated between the first and the second reflecting mirrors 12 and 19 transmits through the first reflecting mirror 12 and the substrate 11 and is taken to the outside. Thus, the surface emitting laser 10 emits the light in the direction perpendicular to the substrate 11 and the light-emitting structure layer EM1.

The projection 15B of the p-type semiconductor layer 15 in the light-emitting structure layer EM1 defines a luminescence center as a center of the luminescence region in the light-emitting layer 14 and defines a center axis (luminescence center axis) CA of the resonator OC1. The central axis CA of the resonator OC1 passes through the center of the projection 15B of the p-type semiconductor layer 15 and extends in the direction perpendicular to the p-type semiconductor layer 15 (light-emitting structure layer EM1).

The luminescence region of the light-emitting layer 14 is, for example, a region with a predetermined width from which a light with a predetermined intensity or more is emitted in the light-emitting layer 14, and the center of which is a luminescence center. For example, the luminescence region of the light-emitting layer 14 is a region to which the current having a predetermined density or more is injected in the light-emitting layer 14, and the center of which is a luminescence center. A straight line that passes through the luminescence center and is perpendicular to the substrate 11 is the central axis CA. The luminescence central axis CA is the straight line that extends along a direction of resonator length of the resonator OC1 constituted by the first and the second reflecting mirrors 12 and 19. The central axis CA corresponds to an optical axis of a laser beam emitted from the surface emission laser 10.

Here, an exemplary configuration of each layer in the surface emitting laser 10 will be described. In this embodiment, the first reflecting mirror 12 is formed of 44 pairs of GaN layers and AlInN layers. The n-type semiconductor layer 13 has a layer thickness of 650 nm. The light-emitting layer 14 is formed of an active layer having a multiple quantum well structure in which 4 nm of InGaN layers and 5 nm of GaN layers are stacked three times. The second reflecting mirror 19 is formed of 10 pairs of Ta₂O₅ layers and Al₂O₃ layers.

The p-type semiconductor layer 15 has a layer thickness of 50 nm in the region of the projection 15B. The p-type semiconductor layer 15 has a layer thickness of 30 nm in a region of the upper surface 15A. The projection 15B has an outer diameter of 10 µm. The insulating layer 16 has a layer thickness of 20 nm. The upper surface of the insulating layer 16 is formed to be arranged at the same height position as the upper end surface of the projection 15B of the p-type semiconductor layer 15. Note that these are merely one example.

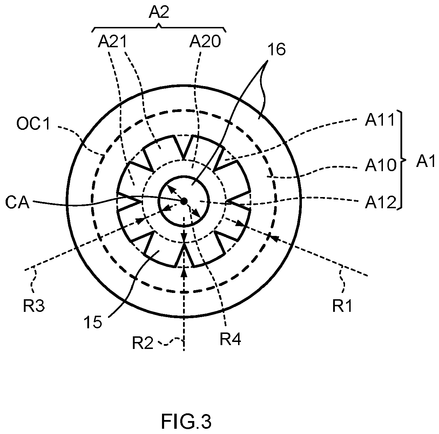

FIG. 3 is a drawing illustrating a detailed configuration of the high resistance region A1 and the low resistance region A2 in the semiconductor structure layer EM1. FIG. 3 is a drawing schematically illustrating a region at the proximity of the resonator OC1 in FIG. 1 in an enlarged view. Using FIG. 3, a detailed configuration of the light-emitting structure layer EM1 will be described.

In the light-emitting structure layer EM1, the high resistance region A1 has an outer circumference region (a high resistance outer circumference region) A10, a plurality of partial regions (high resistance partial regions) A11, and an inner region (a high resistance inner region) A12. The outer circumference region A10 is arranged into a ring shape and constitutes outer periphery portions of the light-emitting structure layer EM1 and the resonator OC1 when viewed in a direction perpendicular to the light-emitting structure layer EM1 (in the plane of the light-emitting structure layer EM1). The plurality of partial regions A11 are arranged inside the outer circumference region A10 and arranged into a ring shape separated from one another. The inner region A12 is arranged into a columnar shape separated from the partial regions A11 inside the partial regions A11.

In this embodiment, the outer circumference region A10 of the high resistance region A1 is arranged into a circular ring shape. Each of the partial regions A11 is a high resistance portion that extends toward the inside of the outer circumference region A10 from the internal surface of the outer circumference region A10. The inner region A12 is a high resistance portion in a column shape arranged at the center of the resonator OC1 including the luminescence central axis CA.

In this embodiment, each of the partial regions A11 extends in a mutually identical length toward the center of the outer circumference region A10 and is arranged in a rotation symmetric manner based on the center of the outer circumference region A10. For example, in this embodiment, each of the partial regions A11 is disposed to extend into a comb shape and a cone shape from the outer circumference region A10.

The low resistance region A2 is disposed inside the outer circumference region A10 of the high resistance region A1. The low resistance region A2 has an inner region (a low resistance inner region) A20 disposed into a ring shape inside the outer circumference region A10 and a plurality of partial regions (low resistance partial regions) A21 each of which is disposed into a ring shape outside the inner region A20 and disposed between the partial regions A11 of the high resistance region A1. Inside the inner region A20 in the low resistance region A2, the inner region A12 of the high resistance region A1 is disposed.

In this embodiment, the inner region A20 of the low resistance region A2 has a circular ring shape and its center is formed to be arranged at the center of the outer circumference region A10 of the high resistance region A1. Each of the partial regions A21 is a low resistance portion extending toward outside of the inner region A20 from the outer surface of the inner region A20 and enters between the respective partial regions A11 of the high resistance region A1.

In this embodiment, the respective partial regions A21 radially extend with the mutually identical lengths from the inner region A20 and is arranged in a rotation symmetric manner in the plane of the light-emitting structure layer EM1 based on the center of the inner region A20. For example, in this embodiment, each of the partial regions A21 is disposed to extend into a comb shape and a columnar shape from the inner region A20. For example, each of the partial regions A21 of the low resistance region A2 extends from the inner region A20 with a width of approximately 2 to 3 µm in a circumferential direction about the luminescence central axis CA.

The projection 15B of the p-type semiconductor layer 15 as the low resistance region A2 of the light-emitting structure layer EM1 is disposed in a region between the first reflecting mirror 12 and the second reflecting mirror 19. Accordingly, in this embodiment, the resonator OC1 has four regions disposed between the first and second reflecting mirrors 12 and 19 and coaxial with the luminescence central axis CA.

Specifically, the resonator OC1 has a first region R1 and a second region R2. The first region R1 tubularly (in this embodiment, cylindrically) extends between the first and second reflecting mirrors and includes only the high resistance region A1, and constitutes the outer circumference region of the resonator OC1. The second region R2 is tubularly (in this embodiment, cylindrically) disposed inside the first region R1 and includes the high resistance regions A1 and the low resistance regions A2 alternately arranged in the circumferential direction.

The resonator OC1 has a third region R3 and a fourth region R4. The third region R3 is tubularly (in this embodiment, cylindrically) disposed inside the second region R2 and includes only the low resistance region A2, and the fourth region R4 is disposed into a column shape (in this embodiment, into a columnar shape) inside the third region R3 and includes only the high resistance region A1.

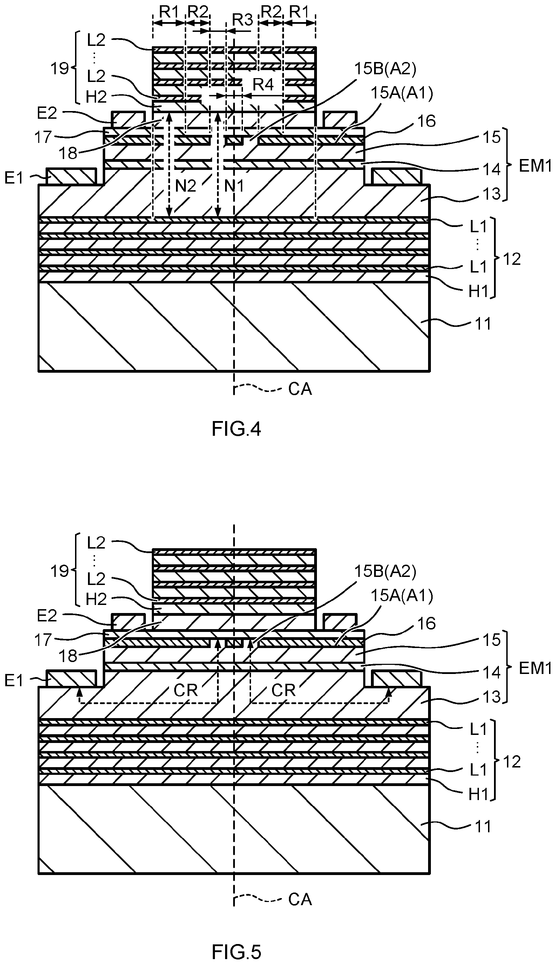

FIG. 4 is a drawing schematically illustrating an optical property in the resonator OC1 of the surface emission laser 10. FIG. 4 is a cross-sectional view similar to FIG. 2. In this embodiment, the insulating layer 16 has a refractive index lower than that of the p-type semiconductor layer 15 and is formed at the same height as the top end surface of the projection 15B of the p-type semiconductor layer 15. Layer thicknesses of the other layers between the first and the second reflecting mirrors 12 and 19 are each constant.

Accordingly, equivalent refractive indexes (which are optical distances between the first and second reflecting mirrors 12 and 19, and correspond to resonant wavelengths) in the resonator OC1 are different between the high resistance region A1 and the low resistance region A2 depending on a difference in refractive index between the p-type semiconductor layer 15 and the insulating layer 16.

Specifically, as illustrated in FIG. 4, for example, an equivalent refractive index between the first and second reflecting mirrors 12 and 19 in the region corresponding to the low resistance region A2 of the second and third regions R2 and R3 is assumed to be a refractive index N1 and an equivalent refractive index between the first and second reflecting mirrors 12 and 19 in the region corresponding to the high resistance region A1 of the first, second, and fourth regions R1, R2, and R4 is assumed to be a refractive index N2. In this case, the refractive index N2 is smaller than the refractive index N1. That is, the equivalent resonant wavelength in the low resistance region A2 is smaller than the equivalent resonant wavelength in the high resistance region A1.

In other words, the resonator OC1 has a low refractive index region (the first region R1, a part of the second region R2, and the fourth region R4) extending between the first and second reflecting mirrors 12 and 19 corresponding to the high resistance region A1 of the light-emitting structure layer EM1, and a high refractive index region (a part of the second region R2 and the third region R3) extending between the first and second reflecting mirrors 12 and 19 corresponding to the low resistance region A2 and having an equivalent refractive index larger than that in the low refractive index region.

FIG. 5 is a drawing schematically illustrating an electrical property in the resonator OC1 (inside the light-emitting structure layer EM1) of the surface emission laser 10. FIG. 5 is a drawing schematically illustrating a current CR flowing in the light-emitting structure layer EM1. FIG. 5 is a cross-sectional view similar to that in FIG. 2.

In this embodiment, the high resistance region A1 is made to become highly resistant by being covered with the insulating layer 16. Accordingly, the current CR is injected into the light-emitting structure layer EM1 only via the low resistance region A2. The current confinement structure by the insulating layer 16 is disposed extremely close to the light-emitting layer 14 and the current CR is less likely to expand in the in-plane direction of the light-emitting layer 14.

Therefore, as illustrated in FIG. 5, the current CR flows only to the light-emitting layer 14 and the region at the proximity thereof in the second and third regions R2 and R3 corresponding to the inner region A20 and the partial regions A21 of the low resistance region A2. The current is hardly injected into the region of the light-emitting layer 14 in the first and fourth regions R1 and R4. Accordingly, while a light is generated (a gain is generated) in the second and third regions R2 and R3, a light is not generated in the first and fourth regions R1 and R4.

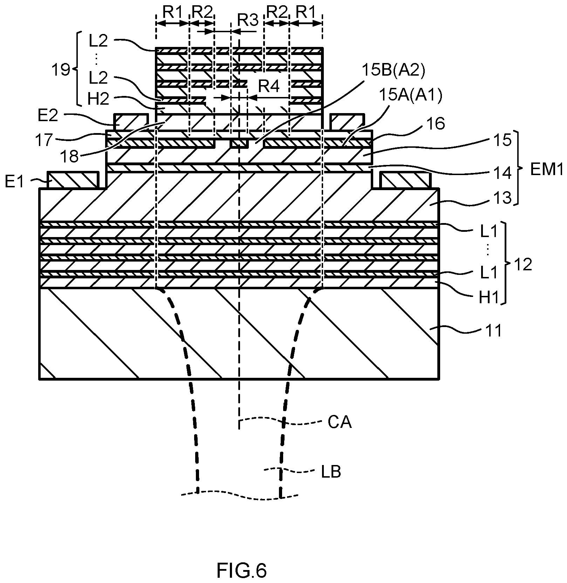

FIG. 6 is a drawing schematically illustrating a laser beam LB emitted from the surface emission laser 10. In this embodiment, a standing wave inside the surface emission laser 10 is taken out to the outside from the first reflecting mirror 12. The laser beam LB is while converging to the first region R1, taken out to the outside as illustrated in FIG. 6. Note that FIG. 6 schematically illustrates an outer edge of the shape of the laser beam LB emitted from the surface emission laser 10 by a dashed line.

Specifically, first, in this embodiment, as described above, the refractive index of the insulating layer 16 is smaller than a refractive index of the p-type semiconductor layer 15 (the projection 15B). Accordingly, a difference in equivalent refractive index is provided between the first to fourth regions R1 to R4 in the resonator OC1. In this embodiment, the refractive index N2 of the resonator OC1 (a laser medium) in the first region R1 is smaller than the refractive index N1 of the resonator OC1 in the second and third regions R2 and R3.

In this embodiment, the high resistance region A1 has the outer circumference region A10 surrounding the low resistance region A2. Accordingly, the resonator OC1 has the low refractive index region (the first region R1) extending between the first and second reflecting mirrors 12 and 19 corresponding to the outer circumference region A10 of the high resistance region A1 of the light-emitting structure layer EM1 and the high refractive index regions (the second and third regions R2 and R3) that is disposed inside the low refractive index region corresponding to the low resistance region A2 and has an equivalent refractive index larger than that of the low refractive index region.

This suppresses an optical loss caused by the standing wave inside the resonator OC1 scattering (radiating) outside from the second and third regions R2 and R3. That is, a large quantity of light stays inside the second region R2, and the laser beam LB is taken outside in this state. Accordingly, a large quantity of light concentrates on the luminescence central axis CA of the resonator OC1 and the laser beam LB with a high output power can be generated and emitted.

In this embodiment, a light guide structure (a light confinement structure) by providing a difference in refractive index is formed in the resonator OC1. Accordingly, almost all the lights become the laser beam LB inside the resonator OC1 without being loss. Accordingly, the laser beam LB with high efficiency and high output power can be generated and emitted.

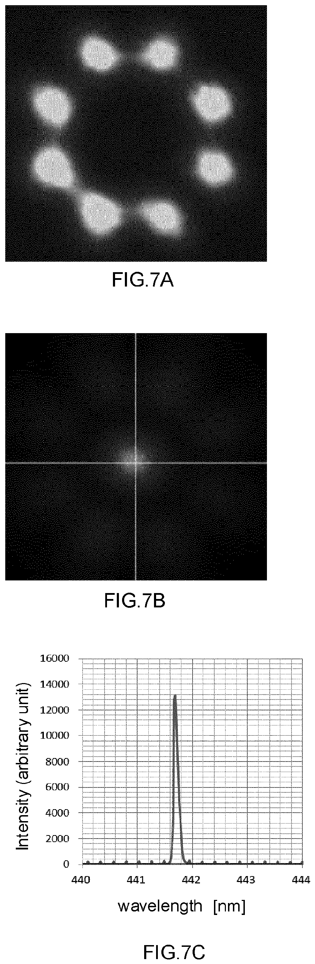

Next, using FIG. 7A, FIG. 7B, and FIG. 7C, oscillation modes of the laser beam LB will be described. FIG. 7A is a drawing illustrating a near-field pattern of the laser beam LB. FIG. 7B is a drawing illustrating a far-field pattern of the laser beam LB. FIG. 7C is a drawing illustrating a wavelength property of the laser beam LB.

As described above, in this embodiment, in the light-emitting structure layer EM1, a region in which the partial regions A11 of the high resistance region A1 and the partial regions A21 of the low resistance region A2 are arranged into a ring shape and in an alternating manner is disposed. That is, in the resonator OC1, as the second region R2, a region in which regions through which the current is injected into the light-emitting layer 14 scatter into a ring shape is disposed. This considerably stabilizes the eigenmode of the laser beam LB.

Specifically, in the second region R2, a development position of the standing wave constituting the laser beam LB can be fixed to the partial regions A21 of the low resistance region A2. Accordingly, the standing wave that develops in scattered manner in this second region R2 can be interfered ideally (as designed). Then, the standing waves interfered with one another are emitted as the laser beam LB in an eigenmode as designed.

For example, as illustrated in FIG. 7A, in the near-field pattern, a light emission pattern having intensity peaks at positions corresponding to the partial regions A21 of the low resistance region A2 is formed. This is caused by the standing wave in the resonator OC1 being confined inside the partial regions A21 and the position of the standing wave in the circumferential direction of the luminescence central axis CA being fixed. In other words, disposing the partial regions A21 ensures controlling the light emission pattern of the surface emission laser 10 also in the circumferential direction of the optical axis.

As illustrated in FIG. 7B, in the far-field pattern, a unimodal beam pattern having an intensity peak at one point on the luminescence central axis CA is formed. Thus, generating a near-field pattern with the light emission pattern as designed generates an interference phenomenon of light as designed, thereby generating the far-field pattern as designed. That is, the laser beam LB in a considerably stable eigenmode is emitted.

Disposing the partial regions A21 substantially enlarges a range of an injection current that can generate the stable far-field pattern. Even when a large current is applied for obtaining the laser beam LB with a large light amount, such as when a light with high output power is required as with, for example, a vehicle lamp, the developed mode is less likely to be unstable. Accordingly, it serves as a light source appropriate for, for example, a usage that requires the laser beam LB with a stable high output power.

Note that when the partial regions A21 are not disposed, a position of the standing wave in the peripheral area of the luminescence central axis CA, that is a position in a circumferential direction of the luminescence central axis CA of the light emission pattern is not specified. This case, as the injection current increases, there occurs a case where the stable unimodal laser beam LB cannot be obtained or a case where the laser beam LB becomes a multi-mode.

This is caused because the position of the standing wave in the peripheral area of the luminescence central axis CA becomes unstable. For example, the standing wave in the resonator OC1 causes an unstable interference, and the mode of the laser beam becomes unstable. Examples of unstable far-field pattern include a generation of a beam pattern having a plurality of intensity peaks into a ring shape.

In contrast to this, in this embodiment, the low resistance region A2 has the partial regions A21 in a ring shape, thereby fixing the position of the standing wave. Accordingly, even when the intensity of the light (the standing wave) in the resonator OC1 is increased by changing the injection current, a spatial magnitude relationship of the intensity is stabilized. Accordingly, the interference condition of the light is stabilized and the laser beam LB with a stable pattern can be obtained.

Note that adjusting, for example, positions, the number, shapes, sizes, and the like of the partial regions A21 of the low resistance region A2 ensure adjusting the interference conditions of the standing wave, that is, the beam pattern of the laser beam LB.

This, for example, corresponds to generation conditions of an interference fringe of the light caused by an optical slit. For example, a size (a width) in the circumferential direction of the partial region A21 corresponds to a slit width. An interval between the neighboring partial regions A21 corresponds to a slit interval. For example, designing these configurations considering the wavelength of the light emitted from the light-emitting layer 14 ensures stably obtaining the laser beam LB in a transverse mode as designed.

FIG. 7C is a drawing illustrating a wavelength property of the laser beam LB. As illustrated in FIG. 7C, it is seen that the laser beam LB is a light having approximately a single wavelength. The wavelength of this laser beam LB corresponds to a resonant wavelength (that is, an optical distance) of the third region R3 in the resonator OC1. Thus, it is seen that the laser beam LB is a light having a unimodal intensity distribution with a single wavelength (a longitudinal mode). The surface emission laser 10 is a high performance and high output power light-emitting device that can stably emits such a laser beam LB.

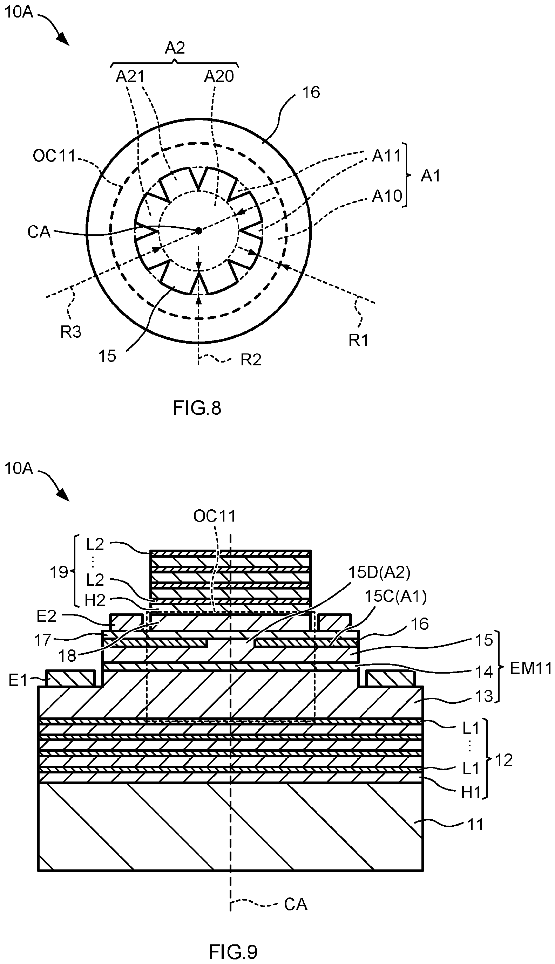

FIG. 8 is a schematic top view of a resonator OC11 in a surface emission laser 10A according to Modification 1 of this embodiment. FIG. 9 is a cross-sectional view of the surface emission laser 10A. The surface emission laser 10A has a configuration similar to that of the surface emission laser 10 except for configurations of the high resistance region A1 and the low resistance region A2. In this modification, the resonator OC11 has a configuration similar to that of the resonator OC1 except that the resonator OC11 does not have the fourth region R4.

In this modification, the p-type semiconductor layer 15 has a projection 15D that, while having a radiate portion, is in an approximately columnar shape instead of the projection 15B. Specifically, the p-type semiconductor layer 15 has an upper surface 15C and the projection 15D that projects into an approximately columnar shape from the upper surface 15C. In this modification, the insulating layer 16 is disposed on the upper surface 15C of the p-type semiconductor layer 15. The p-type semiconductor layer 15 is exposed from the insulating layer 16 in the projection 15D. The light-transmitting electrode layer 17 is in contact with the p-type semiconductor layer 15 in the projection 15D.

Accordingly, in the center of the resonator OC11, the high resistance region A1 is not disposed. That is, the high resistance region A1 is made only of the outer circumference region A10 and the partial regions A11. The low resistance region A2 has the inner region A20 in a columnar shape and a plurality of the partial regions A21 extending into a comb shape outside the inner region A20.

For example, as long as the second region R2, that is, the region in which the high resistance regions A1 and the low resistance regions A2 are alternately arranged is disposed, the configuration in the resonator is not limited to the above. For example, as illustrated in this modification, the high resistance region A1 is not necessarily disposed on the luminescence central axis CA. Also in this case, the low resistance region A2, with the plurality of partial regions A21 in a ring shape, ensures the stabilized mode of the laser beam LB, and therefore, the low resistance region A2 can emit the laser beam LB with the stable beam pattern, for example, even when the injection current is increased.

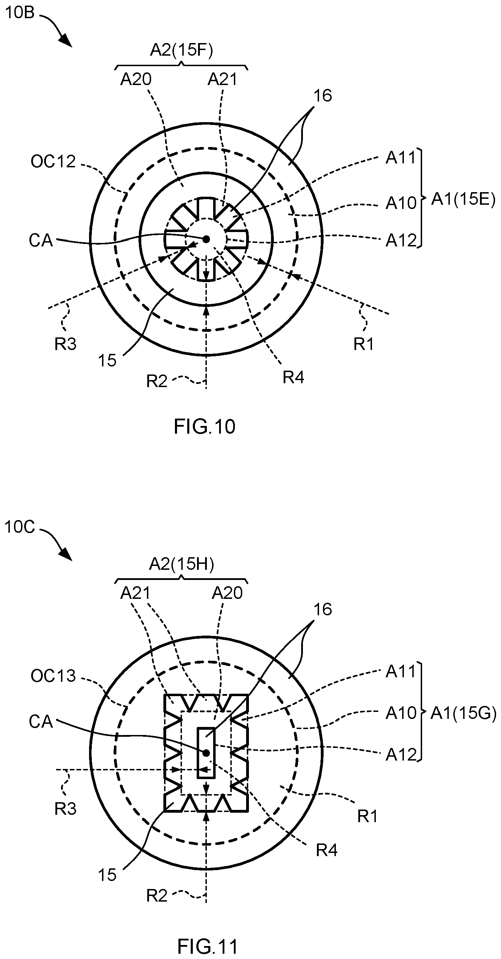

FIG. 10 is a schematic top view of a resonator OC12 of a surface emission laser 10B according to Modification 2 of this embodiment. The surface emission laser 10B has a configuration similar to a configuration of the surface emission laser 10 except for a configuration of the p-type semiconductor layer 15 and a configuration of the resonator OC12. The resonator OC12 has a configuration similar to that of the resonator OC1 except that a region in which the high resistance region A1 and the low resistance region A2 are mixed in the third region R3 is disposed.

In this modification, the p-type semiconductor layer 15 has a projection 15F in an approximately circular ring shape internally having a radiate portion instead of the projection 15B. Specifically, the p-type semiconductor layer 15 has an upper surface 15E and the projection 15F that projects into a ring shape from the upper surface 15E and has a side surface having a plurality of radiate portions approaching the center inside thereof. Note that the configurations of the insulating layer 16 and the light-transmitting electrode layer 17 are similar to those described above.

In this modification, the low resistance region A2 has the inner region A20 that is in contact with the inside of the outer circumference region A10 of the high resistance region A1 and disposed into a ring shape and the plurality of partial regions A21 disposed into a ring shape inside the inner region A20 and separated with one another. In this modification, each of the partial regions A21 is a low resistance portion extending into a cone shape toward the center of the inner region A20 from the internal surface of the inner region A20.

In this modification, the high resistance region A1 has the outer circumference region A10 and the inner region A12, and the plurality of partial regions A11 each of which is in contact with the inner region A12 and is disposed into a ring shape so as to enter between the partial regions A21 of the low resistance region A2.

In this modification, the low resistance region A2 has the partial regions A21 inside the inner region A20. Accordingly, the resonator OC12 has a region in which the high resistance regions A1 and the low resistance regions A2 are alternately arranged in the third region R3, not in the second region R2.

As in this modification, the partial regions A21 of the low resistance region A2 can be disposed at various positions. Also in this case, the mode of the laser beam LB is stabilized by the partial regions A21, for example, the unimodal laser beam LB can be stably emitted.

FIG. 11 is the schematic top view of a resonator OC13 of a surface emission laser 10C according to Modification 3 of this embodiment. The surface emission laser 10C has a configuration similar to that of the surface emission laser 10 except for a configuration of the p-type semiconductor layer 15 and a configuration of the resonator OC13. The resonator OC13 has a configuration similar to that of the resonator OC1 except that the resonator OC13 has the second to fourth regions R2 to R4 in rectangular.

In this modification, the p-type semiconductor layer 15 has an upper surface 15G and a projection 15H having a configuration similar to that of the projection 15B except that it projects into an approximately rectangular shape from the upper surface 15G. In this modification, the high resistance region A1 has the plurality of partial regions A11 arranged into a rectangular ring shape inside the outer circumference region A10 and the rectangular inner region A12. The low resistance region A2 has the inner region A20 in a rectangular ring shape and the plurality of partial regions A21 disposed into a rectangular ring shape outside the inner region A20.

As in this modification, for example, the second region R2 may have a rectangular shape as long as it is disposed into a ring shape. Also in this case, the mode of the laser beam LB is stabilized by the partial regions A21, and therefore, for example, the unimodal laser beam LB can be stably emitted.

The configurations of the high resistance region A1 and the low resistance region A2 described above are merely an example. For example, the low resistance region A2 does not necessarily have the inner region A20. That is, it is only necessary that the low resistance region A2 has the plurality of partial regions A21 disposed into a ring shape. Also, it is only necessary that the high resistance region A1 has at least the plurality of partial regions A11 disposed between the partial regions A21 of the low resistance region A2.

Accordingly, the whole low resistance region A2 may be scattered in the light-emitting structure layer EM1. Note that when stabilizing the injection current into the light-emitting structure layer EM1 by each partial region A21 is taken into consideration, it is preferred that the region that electrically connects each of the partial regions A21, for example, the inner region A20 is disposed.

This embodiment has described, not only providing the difference in electrical resistance between the high resistance region A1 and the low resistance region A2, but also the case where the difference in equivalent refractive index is provided corresponding to these regions. However, when the mode control of the laser beam LB is taken into consideration, it is only necessary that the difference in electrical resistance is provided at least between these regions.

As described above, in this embodiment, the light-emitting structure layer EM1 is disposed between the first and second reflecting mirrors 12 and 19, and each of them has the high resistance region A1 disposed in plane of the light-emitting structure layer EM1 and the low resistance region A2 having an electrical resistance lower than that of the high resistance region A1. The low resistance region A2 has the plurality of partial regions A21 arranged into a ring shape while being separated by the high resistance region A1 in an in-plane direction of the light-emitting structure layer EM1. Accordingly, the surface emission laser 10 (the vertical cavity surface emitting device) that can emit the light in a stable transverse mode can be provided.

### Embodiment 2

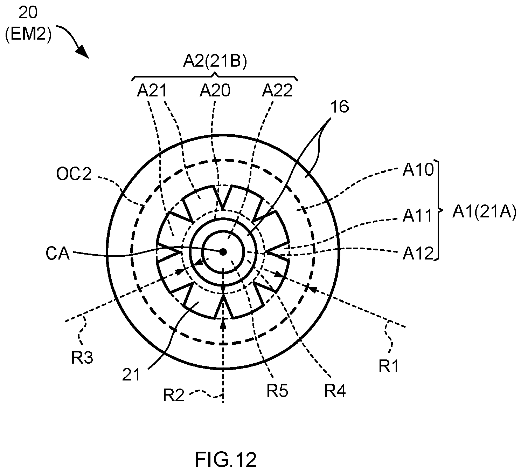

FIG. 12 is a schematic top view of a resonator OC2 of a surface emission laser 20 according to Embodiment 2. The surface emission laser 20 has a configuration similar to that of the surface emission laser 10 except for a configuration of a light-emitting structure layer EM2 and a configuration of the resonator OC2. The resonator OC2 has a configuration similar to that of the resonator OC1 except that the resonator OC2 has a fifth region R5 corresponding to the low resistance region inside the fourth region R4.

In this embodiment, the light-emitting structure layer EM2 has a p-type semiconductor layer 21 instead of the p-type semiconductor layer 15. The p-type semiconductor layer 21 has an upper surface 21A and a projection 21B having a ring-shaped portion projecting into an approximately ring shape from the upper surface 21A and a columnar portion projecting into a column shape inside the ring-shaped portion. In this embodiment, a whole of the n-type semiconductor layer 13, the light-emitting layer 14, and the p-type semiconductor layer 21 is referred to as the light-emitting structure layer EM2. Note that the insulating layer 16 and the light-transmitting electrode layer 17 have a configuration similar to that of the surface emission laser 10.

Accordingly, in this embodiment, the inner region A12 of the high resistance region A1 is disposed into a ring shape (in this embodiment, a circular ring shape). The low resistance region A2 has a central region A22 disposed inside the inner region A12 of the high resistance region A1. In this embodiment, the central region A22 of the low resistance region A2 has a columnar shape.

In this embodiment, the low resistance region A2 has the central region A22 surrounded by the high resistance region A1 in a region on the luminescence central axis CA. This ensures stabilizing the light emission pattern on the luminescence central axis CA not only controlling the light emission pattern in the peripheral area of the luminescence central axis CA.

In this embodiment, the standing wave can also be stably developed within the central region A22 in addition to developing the standing wave within the partial regions A21. This stabilizes interference conditions of the standing wave of the whole luminescence region to ensure performing a stable transverse mode control of the whole luminescence region.

Accordingly, for example, adjusting a size of the central region A22 and a positional relation with the partial regions A21 can generate the laser beam LB of the beam pattern that hardly generates a side lobe (that is, the far-field pattern). Similarly to Embodiment 1, the beam pattern is stabilized regardless of the magnitude of the injection current. Accordingly, the surface emission laser 20 with high output power and high stability can be provided.

### Embodiment 3

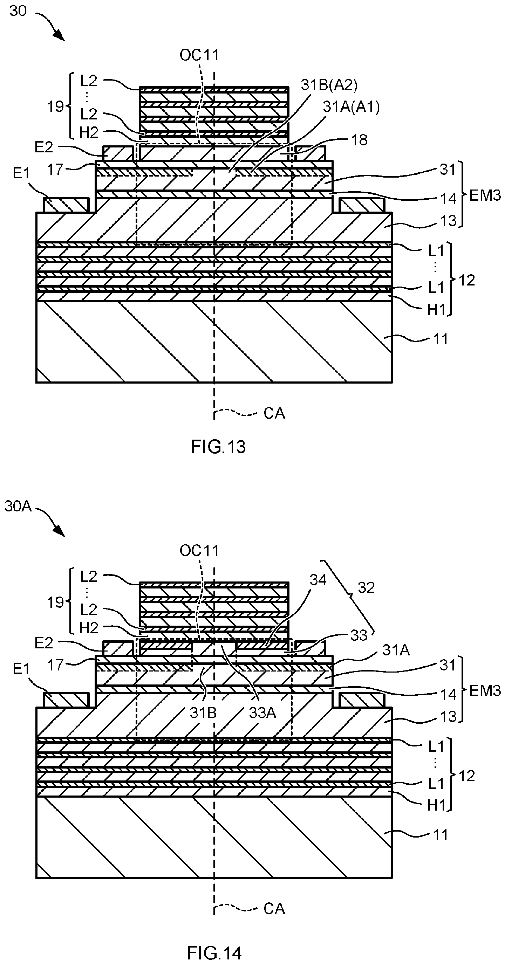

FIG. 13 is a cross-sectional view of a surface emission laser 30 according to Embodiment 3. The surface emission laser 30 has a configuration similar to that of the surface emission laser 10A except for a configuration of a light-emitting structure layer EM3. The light-emitting structure layer EM3 has a configuration similar to that of a light-emitting structure layer EM11 except for a configuration of the high resistance region A1 and the low resistance region A2.

The light-emitting structure layer EM3 has a p-type semiconductor layer (a second semiconductor layer) 31 having an ion implantation region 31A that corresponds to the high resistance region A1 and in which ions are implanted. For example, the ion implantation region 31A is a region on the upper surface of the p-type semiconductor layer 31 in which B ions, A1 ions, or oxygen ions are implanted.

In the ion implantation region 31A, p-type impurities are deactivated. That is, the ion implantation region 31A functions as the high resistance region A1. In the ion implantation region 31A, the refractive index is changed by the ion implantation.

In this embodiment, a region 31B of the p-type semiconductor layer 31 other than the ion implantation region 31A is a non-ion implantation region in which the ions are not implanted. Accordingly, in this embodiment, the non-ion implantation region 31B functions as the low resistance region A2.

In this embodiment, the ion implantation region 31A has an upper surface shape similar to that of the upper surface 15A in the p-type semiconductor layer 15. The non-ion implantation region 31B has an upper surface shape similar to that of the projection 15B in the p-type semiconductor layer 15.

As in this embodiment, the differences can be provided in electrical resistance and refractive index by the presence or absence of the ion implantation. Accordingly, the low resistance region A2 (for example, the inner region A20 and the partial regions A21) can be disposed within the light-emitting structure layer EM3. Accordingly, the surface emission laser 30 that can emit the light in a stable transverse mode can be provided.

FIG. 14 is a cross-sectional view of a surface emission laser 30A according to a modification of Embodiment 3. The surface emission laser 30A has a configuration similar to that of the surface emission laser 30 except that the surface emission laser 30A has an insulating layer (a second insulating layer) 32. The insulating layer 32 is formed between the light-emitting structure layer EM3 and the second reflecting mirror 19 and having refractive indexes different between the regions.

In the surface emission laser 30A, the insulating layer 32 has a high refractive index insulating layer 33 that is formed on the light-transmitting electrode layer 17 and has a projection 33A on the non-ion implantation region 31B and a low refractive index insulating layer 34 that is formed on the high refractive index insulating layer 33 while exposing the projection 33A and has a refractive index lower than that of the high refractive index insulating layer 33. The high refractive index insulating layer 33 is, for example, made of Nb₂O₅. The low refractive index insulating layer 34 is, for example, made of SiO₂.

In this embodiment, in addition to inside the light-emitting structure layer EM3, the insulating layer 32 formed outside thereof provides a difference in refractive index between the high resistance region A1 (the first region R1) and the low resistance region A2 (the second and third regions R3). Then, for example, the p-type semiconductor layer 31 preferentially and reliably defines the difference in electrical resistance between the high resistance region A1 and the low resistance region A2. In addition, the insulating layer 32 enhances the effect of refractive index difference between the high resistance region A1 and the low resistance region A2. Accordingly, the surface emission laser 30A that can emit the light in a stable transverse mode can be provided.

### Embodiment 4

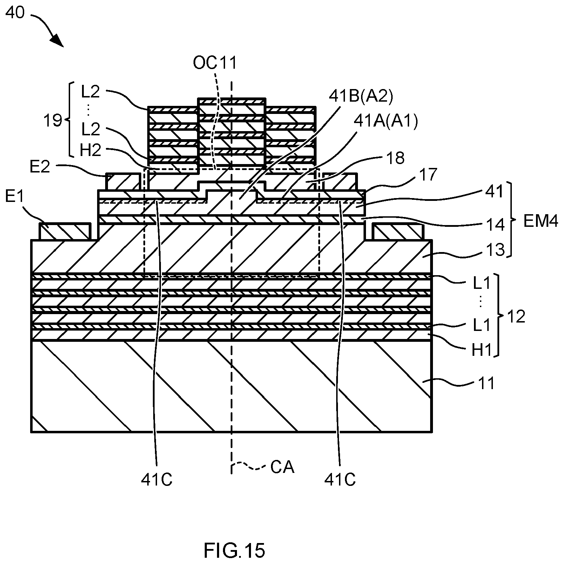

FIG. 15 is a cross-sectional view of a surface emission laser 40 according to Embodiment 4. The surface emission laser 40 has a configuration similar to that of the surface emission laser 10A except for a configuration of a light-emitting structure layer EM4. The light-emitting structure layer EM4 has a configuration similar to that of the light-emitting structure layer EM 11 except for configurations of the high resistance region A1 and the low resistance region A2.

In the surface emission laser 40, the light-emitting structure layer EM4 has a p-type semiconductor layer 41 corresponding to the high resistance region A1 and having an etched portion 41A on which dry etching is performed. The upper surface region where the etching is not performed in the p-type semiconductor layer 41 serves as a projection 41B.

The semiconductor including impurities, such as the p-type semiconductor layer 41, has its surface damaged by performing the dry etching. This deactivates the p-type impurities in the etched portion 41A. That is, the p-type semiconductor layer 41 has the deactivation region 41C in which the p-type impurities are deactivated in a region of the etched portion 41A. Accordingly, the deactivation region 41C functions as the high resistance region A1. The projection 41B on which the etching is not performed functions as the low resistance region A2.

In this embodiment, in the etched portion 41A, the p-type semiconductor layer 41 is partially removed. Accordingly, the region other than the etched portion 41A serves as the projection 41B projecting from the etched portion 41A. In the etched portion 41A, a contact layer generally disposed at an interface with a metal on the semiconductor layer is removed. Accordingly, for example, as in Embodiment 1, without disposing the insulating layer 16, the etched portion 41A is made sufficiently high in resistance.

Accordingly, first, the current is injected into the light-emitting structure layer EM4 only from the projection 41B. The p-type semiconductor layer 41 has different layer thicknesses between the etched portion 41A and the projection 41B. Accordingly, the difference in equivalent refractive index can be provided in the resonator OC11 by the presence or absence of the etching.

Note that when disposing the low resistance region A2 is taken into consideration, it is only necessary that the p-type semiconductor layer 41 selectively has a deactivation region 41C. Accordingly, it is not limited to the case where the p-type semiconductor layer 41 has the etched portion 41A where the dry etching is performed. For example, the deactivation region 41C may be formed by performing the ion implantation or the deactivation region 41C may be formed by performing an ashing process.

In this embodiment, the p-type semiconductor layer (the second semiconductor layer) 41 of the light-emitting structure layer EM4 has the deactivation region 41C corresponding to the high resistance region A1 and having the p-type impurities deactivated. The region 41B in which the impurities of the p-type semiconductor layer 41 are not deactivated functions as the low resistance region A2.

Thus, the differences can be provided in electrical resistance and refractive index also by, for example, selectively performing etching to partially deactivate the p-type semiconductor layer 41. Accordingly, the low resistance region A2 (for example, the inner region A20 and the partial regions A21) can be disposed within the light-emitting structure layer EM4. Accordingly, the surface emission laser 40 that can emit the light in a stable transverse mode can be provided.

### Embodiment 5

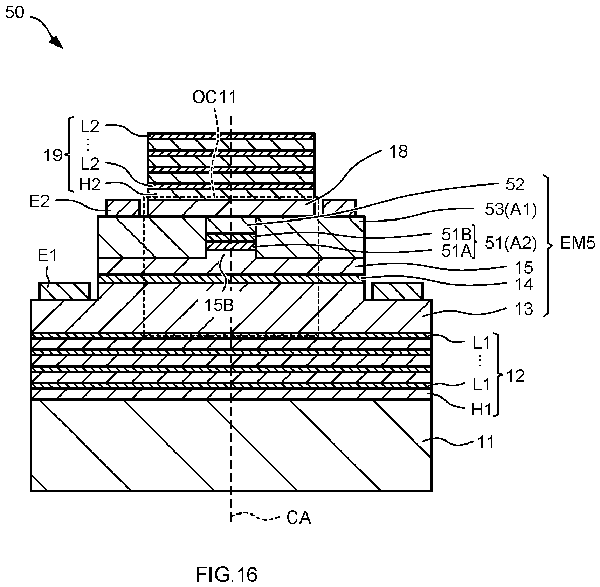

FIG. 16 is a cross-sectional view of a surface emission laser 50 according to Embodiment 5. The surface emission laser 50 has a configuration similar to that of the surface emission laser 10A except for a configuration of a light-emitting structure layer EM5. The light-emitting structure layer EM5 has a configuration similar to that of the light-emitting structure layer EM 11 except for configurations of the high resistance region A1 and the low resistance region A2.

In the surface emission laser 50, the light-emitting structure layer EM5 has a tunnel junction layer 51 that corresponds to the low resistance region A2 and is disposed on the projection 15B of the p-type semiconductor layer 15 and an n-type semiconductor layer (a second n-type semiconductor layer or a third semiconductor layer) 52 disposed on the tunnel junction layer 51.

The light-emitting structure layer EM5 has an n-type semiconductor layer (a third n-type semiconductor layer or a fourth semiconductor layer) 53 that corresponds to the high resistance region A1, surrounds a side surface of the tunnel junction layer 51 and the n-type semiconductor layer 52, and has a refractive index lower than those of the tunnel junction layer 51 and the n-type semiconductor layer 52.

In this embodiment, the tunnel junction layer 51 includes a high dope p-type semiconductor layer 51A that is formed on the p-type semiconductor layer 15 and has an impurity concentration higher than that of the p-type semiconductor layer (the second semiconductor layer) 15 and a high dope n-type semiconductor layer 51B that is formed on the high dope p-type semiconductor layer 51A and has an impurity concentration higher than that of the n-type semiconductor layer (the first n-type semiconductor layer or the first semiconductor layer) 13.

In this embodiment, the n-type semiconductor layer 53 includes Ge as n-type impurities. This causes the n-type semiconductor layer 53 to have a refractive index lower than an average refractive index of the n-type semiconductor layer 52, the tunnel junction layer 51, and the projection 15B of the p-type semiconductor layer 15.

As in this embodiment, even when the current confinement is performed by the tunnel junction, the low resistance region A2 can be formed in the light-emitting structure layer EM5 (for example, the inner region A20 and the partial regions A21) by adjusting its confinement shape. Lowering the refractive index in a region other than the low resistance region A2 ensures defining, for example, the first to third regions R1 to R3. Accordingly, the surface emission laser 50 that can emit the light in a stable transverse mode can be provided.

Note that the embodiments described above are merely an example. For example, various embodiments described above can be combined. For example, the surface emission laser 10 may have the insulating layer 32 similar to that in the surface emission laser 30A. For example, the surface emission laser 40 may have the insulating layer 16 on the deactivation region 41C.

As described above, for example, the surface emission laser 10 has the low resistance region (the current injection region) A2 in which the light-emitting structure layer EM1 has the plurality of partial regions A21 arranged into a ring shape between the first and second reflecting mirrors 12 and 19. This ensures providing the surface emission laser 10 (the vertical cavity surface emitting device) that can emit the light in a stable transverse mode.

It is understood that the foregoing description and accompanying drawings set forth the preferred embodiments of the present invention at the present time. Various modifications, additions and alternative designs will, of course, become apparent to those skilled in the art in light of the foregoing teachings without departing from the scope of the disclosed invention as defined in the appended claims. Thus, it should be appreciated that the present invention is not limited to the disclosed Examples but may be practiced within the full scope of the appended claims.

### DESCRIPTION OF REFERENCE SIGNS

10, 10A, 10B, 10C, 20, 30, 30A, 40, 50 surface emitting laser (vertical cavity surface emitting device)
EM1, EM11, EM12, EM13, EM2, EM3, EM4, EM5 light-emitting structure layer 14 light-emitting layer
A2 low resistance region
A21 partial regions

## Claims

1. A vertical cavity surface emitting device comprising:
a substrate (11);
a first multilayer film reflecting mirror (12) formed on the substrate;
a light-emitting structure layer (EM1) formed on the first multilayer film reflecting mirror, the light-emitting structure layer including a light-emitting layer (14); and
a second multilayer film reflecting mirror (19) formed on the light-emitting structure layer, the second multilayer film reflecting mirror constituting a resonator (OC1) between the first multilayer film reflecting mirror and the second multilayer film reflecting mirror, wherein
the light-emitting structure layer has a high resistance region (A1) and a low resistance region (A2) having an electrical resistance lower than an electrical resistance of the high resistance region,
the low resistance region (A2) has a plurality of partial regions (A21) arranged into a ring shape while being separated by the high resistance region (A1) in a plane of the light-emitting structure layer, and
the low resistance region (A2) has an inner region (A20) disposed inside the plurality of partial regions (A21) and is connected to each of the plurality of partial regions (A21).

2. The vertical cavity surface emitting device according to claim 1, wherein
the plurality of partial regions of the low resistance region are arranged in a rotation symmetric manner in the plane of the light-emitting structure layer.

3. The vertical cavity surface emitting device according to claim 1, wherein
the inner region of the low resistance region is disposed into a ring shape.

4. The vertical cavity surface emitting device according to claim 3, wherein
the high resistance region (A1) has a high resistance inner region (A12) disposed inside the inner region of the low resistance region (A2) and disposed into a ring shape, and
the low resistance region (A2) has a central region (A22) disposed inside the high resistance inner region (A12) and surrounded by the high resistance inner region (A12).

5. The vertical cavity surface emitting device according to any one of claims 1 to 4wherein
the high resistance region has an outer circumference region (A10) surrounding the low resistance region, and
the resonator has a low refractive index region (R1, R2, R4) and a high refractive index region (R2, R3), the low refractive index region extending between the first and second multilayer film reflecting mirrors and corresponding to the outer circumference region of the high resistance region of the light-emitting structure layer, the high refractive index region being disposed inside the low refractive index region and corresponding to the low resistance region, the high refractive index region having an equivalent refractive index larger than an equivalent refractive index of the low refractive index region.

6. The vertical cavity surface emitting device according to any one of claims 1 to 5, wherein
the light-emitting structure layer has a first semiconductor layer (13) formed on the first multilayer film reflecting mirror, the light-emitting layer formed on the first semiconductor layer, and a second semiconductor layer (15) that is formed on the light-emitting layer and has a conductivity type opposite of a conductivity type of the first semiconductor layer, and
the second semiconductor layer has an upper surface (15A) that corresponds to the high resistance region and is covered with an insulating layer (16) and a projection (15B) that corresponds to the low resistance region and projects into a ring shape from the upper surface to be exposed from the insulating layer.

7. The vertical cavity surface emitting device according to any one of claims 1 to 5, wherein
the light-emitting structure layer has a first semiconductor layer (13) formed on the first multilayer film reflecting mirror, the light-emitting layer formed on the first semiconductor layer, and a second semiconductor layer (15) formed on the light-emitting layer, the second semiconductor layer having a conductivity type opposite of a conductivity type of the first semiconductor layer,
the second semiconductor layer has an ion implantation region (31A) corresponding to the high resistance region and having implanted ions and a region not implanted with the ions (31B) corresponding to the low resistance region.

8. The vertical cavity surface emitting device according to any one of claims 1 to 5, wherein
the light-emitting structure layer has a first semiconductor layer (13) formed on the first multilayer film reflecting mirror, the light-emitting layer formed on the first semiconductor layer, and a second semiconductor layer (15) formed on the light-emitting layer, the second semiconductor layer having a conductivity type opposite of a conductivity type of the first semiconductor layer, and
the second semiconductor layer has a deactivation region (41C) corresponding to the high resistance region and having impurities in the second semiconductor layer deactivated and a region corresponding to the low resistance region and having the impurities not deactivated.

9. The vertical cavity surface emitting device according to any one of claims 1 to 5, wherein
the light-emitting structure layer has a first semiconductor layer (13) formed on the first multilayer film reflecting mirror, the light-emitting layer formed on the first semiconductor layer, a second semiconductor layer (15) formed on the light-emitting layer, the second semiconductor layer having a conductivity type opposite of a conductivity type of the first semiconductor layer, and a tunnel junction layer (51) formed on the second semiconductor layer, the tunnel junction layer corresponding to the low resistance region.

10. A vertical cavity surface emitting device comprising:
a substrate (11);
a first multilayer film reflecting mirror (12) formed on the substrate;
a light-emitting structure layer (EM1) formed on the first multilayer film reflecting mirror, the light-emitting structure layer including a light-emitting layer (14); and
a second multilayer film reflecting mirror (19) formed on the light-emitting structure layer, the second multilayer film reflecting mirror constituting a resonator (OC12) between the first multilayer film reflecting mirror and the second multilayer film reflecting mirror, wherein
the light-emitting structure layer has a high resistance region (A1) and a low resistance region (A2) having an electrical resistance lower than an electrical resistance of the high resistance region,
the low resistance region (A2) has a plurality of partial regions (A21) arranged into a ring shape while being separated by the high resistance region (A1) in a plane of the light-emitting structure layer, and
the low resistance region (A2) has an outer region (A20) disposed outside the plurality of partial regions (A21) and is connected to each of the plurality of partial regions (A21).

## Patentansprüche

1. VCSE-Vorrichtung, VCSE = Vertical Cativy Surface Emitter, bzw. Oberflächenemittervorrichtung mit vertikaler Kavität, die Folgendes aufweist:
ein Substrat (11):
einen ersten Reflexionsspiegel mit mehrlagigem Film bzw. Multilayer-Film-Reflexionsspiegel (12), der auf dem Substrat geformt ist;
eine Lichtemissionsstrukturschicht (EM1), die auf dem ersten Multilayer-Film-Reflexionsspiegel geformt ist, wobei die Lichtemissionsstrukturschicht eine Lichtemissionsschicht (14) aufweist; und
einen zweiten Multilayer-Film-Reflexionsspiegel (19), der auf der Lichtemissionsstrukturschicht geformt ist, wobei der zweite Multilayer-Film-Reflexionsspiegel einen Resonator (OC1) zwischen dem ersten Multilayer-Film-Reflexionsspiegel und dem zweiten Multilayer-Film-Reflexionsspiegel bildet, wobei
die Lichtemissionsstrukturschicht eine Region (A1) mit hohem Widerstand und eine Region (A2) mit niedrigem Widerstand mit einem elektrischen Widerstand hat, der geringer ist als ein elektrischer Widerstand der Region mit hohem Widerstand,
wobei die Region (A2) mit niedrigem Widerstand eine Vielzahl von Teilregionen (A21) hat, die in einer Ringform angeordnet sind, während sie durch die Region (A1) mit hohem Widerstand getrennt sind, und zwar in einer Ebene der Lichtemissionsstrukturschicht, und
wobei die Region (A2) mit niedrigem Widerstand eine innere Region (A20) hat, die innerhalb der Vielzahl von Teilregionen (A21) angeordnet ist und mit jeder der Vielzahl von Teilregionen (A21) verbunden ist.

2. VCSE-Vorrichtung nach Anspruch 1, wobei die Vielzahl von Teilregionen der Region mit niedrigem Widerstand in rotationssymmetrischer Weise in der Ebene der Lichtemissionsstrukturschicht angeordnet sind.

3. VCSE-Vorrichtung nach Anspruch 1, wobei
die innere Region der Region mit niedrigem Widerstand in einer Ringform angeordnet ist.

4. VCSE-Vorrichtung nach Anspruch 3, wobei
die Region (A1) mit hohem Widerstand eine innere Region (A12) mit hohem Widerstand hat, die innerhalb der inneren Region der Region (A2) mit niedrigem Widerstand angeordnet ist und in einer Ringform angeordnet ist, und
wobei die Region (A2) mit niedrigem Widerstand eine mittige Region (A22) hat, die innerhalb der inneren Region (A12) mit hohem Widerstand angeordnet ist und von der inneren Region (A12) mit hohem Widerstand umgeben ist.

5. VCSE-Vorrichtung nach einem der Ansprüche 1 bis 4, wobei
die Region mit hohem Widerstand eine Außenumfangsregion (A10) hat, welche die Region mit niedrigem Widerstand umgibt, und
wobei der Resonator eine Region (R1, R2, R4) mit niedrigem Brechungsindex und eine Region (R2, R3) mit hohem Brechungsindex hat, wobei die Region mit niedrigem Brechungsindex sich zwischen den ersten und zweiten Multilayer-Film-Reflexionsspiegeln erstreckt und der Außenumfangsregion der Region mit hohem Widerstand der Lichtemissionsstrukturschicht entspricht, wobei die Region mit hohem Brechungsindex innerhalb der Region mit niedrigem Brechungsindex angeordnet ist und der Region mit niedrigem Widerstand entspricht, wobei die Region mit hohem Brechungsindex einen äquivalenten Brechungsindex hat, der größer ist als ein äquivalenter Brechungsindex der Region mit niedrigem Brechungsindex.

6. VCSE-Vorrichtung nach einem der Ansprüche 1 bis 5, wobei
die Lichtemissionsstrukturschicht eine erste Halbleiterschicht (13) hat, die auf dem ersten Multilayer-Film-Reflexionsspiegel geformt ist, die Lichtemissionsschicht, die auf der ersten Halbleiterschicht geformt ist, und eine zweite Halbleiterschicht (15), die auf der Lichtemissionsschicht geformt ist und einen Leitfähigkeitstyp entgegengesetzt zu einem Leitfähigkeitstyp der ersten Halbleiterschicht hat, und
wobei die zweite Halbleiterschicht eine Oberseite (15A) hat, die der Region mit hohem widerstand entspricht und mit einer isolierenden Schicht (16) bedeckt ist, und einen Vorsprung (15B), der der Region mit niedrigem Widerstand entspricht und in eine Ringform von der Oberseite vorsteht, so dass sie von der isolierenden Schicht freigelegt bzw. exponiert ist.

7. VCSE-Vorrichtung nach einem der Ansprüche 1 bis 5, wobei
die Lichtemissionsstrukturschicht eine erste Halbleiterschicht (13) hat, die auf dem ersten Multilayer-Film-Reflexionsspiegel geformt ist, die Lichtemissionsschicht, die auf der ersten Halbleiterschicht geformt ist, und eine zweite Halbleiterschicht, die auf der Lichtemissionsschicht geformt ist, wobei die zweite Halbleiterschicht einen Leitfähigkeitstyp entgegengesetzt zu einem Leitfähigkeitstyp der ersten Halbleiterschicht hat,
wobei die zweite Halbleiterschicht eine lonenimplantationsregion (31A) entsprechend der Region mit hohem Widerstand und implantierte Ionen hat und eine Region, die nicht mit den Ionen (31B) implantiert ist, entsprechend der Region mit niedrigem Widerstand.

8. VCSE-Vorrichtung nach einem der Ansprüche 1 bis 5, wobei
die Lichtemissionsstrukturschicht eine erste Halbleiterschicht (13) hat, die auf dem ersten Multilayer-Film-Reflexionsspiegel geformt ist, die Lichtemissionsschicht, die auf der ersten Halbleiterschicht geformt ist, und eine zweite Halbleiterschicht (15), die auf der Lichtemissionsschicht geformt ist, wobei die zweite Halbleiterschicht einen Leitfähigkeitstyp entgegengesetzt zu einem Leitfähigkeitstyp der ersten Halbleiterschicht hat, und
wobei die zweite Halbleiterschicht eine Deaktivierungsregion (41C) entsprechend der Region mit hohem Widerstand hat und Verunreinigungen in der zweiten Halbleiterschicht hat, die deaktiviert sind, und eine Region entsprechend der Region mit niedrigem Widerstand, und in der die Verunreinigungen nicht deaktiviert sind.

9. VCSE-Vorrichtung nach einem der Ansprüche 1 bis 5, wobei
die Lichtemissionsstrukturschicht eine erste Halbleiterschicht (13) hat, die auf dem ersten Multilayer-Film-Reflexionsspiegel geformt ist, die Lichtemissionsschicht, die auf der ersten Halbleiterschicht geformt ist, eine zweite Halbleiterschicht (15), die auf der Lichtemissionsschicht geformt ist, wobei die zweite Halbleiterschicht einen Leitfähigkeitstyp entgegengesetzt zu einem Leitfähigkeitstyp der ersten Halbleiterschicht hat, und eine Tunnelverbindungs- bzw. Tunnel-Junction-Schicht (51),die auf der zweiten Halbleiterschicht geformt ist, wobei die Tunnel-Junction-Schicht der Region mit niedrigem Widerstand entspricht.

10. VCSE-Vorrichtung, VCSE = Vertical Cativy Surface Emitter, bzw. Oberflächenemittervorrichtung mit vertikaler Kavität, die Folgendes aufweist:
ein Substrat (11):
einen ersten Reflexionsspiegel mit mehrlagigem Film bzw. Multilayer-Film-Reflexionsspiegel (12), der auf dem Substrat geformt ist;
eine Lichtemissionsstrukturschicht (EM1), die auf dem ersten Multilayer-Film-Reflexionsspiegel geformt ist, wobei die Lichtemissionsstrukturschicht eine Lichtemissionsschicht (14) aufweist; und
einen zweiten Multilayer-Film-Reflexionsspiegel (19), der auf der Lichtemissionsstrukturschicht geformt ist, wobei der zweite Multilayer-Film-Reflexionsspiegel einen Resonator (OC12) zwischen dem ersten Multilayer-Film-Reflexionsspiegel und dem zweiten Multilayer-Film-Reflexionsspiegel bildet, wobei
die Lichtemissionsstrukturschicht eine Region (A1) mit hohem Widerstand und eine Region (A2) mit niedrigem Widerstand mit einem elektrischen Widerstand hat, der geringer ist als ein elektrischer Widerstand der Region mit hohem Widerstand,
wobei die Region (A2) mit niedrigem Widerstand eine Vielzahl von Teilregionen (A21) hat, die in einer Ringform angeordnet sind, während sie durch die Region (A1) mit hohem Widerstand getrennt sind, und zwar in einer Ebene der Lichtemissionsstrukturschicht, und
wobei die Region (A2) mit niedrigem Widerstand eine äußere Region (A20) hat, die außerhalb der Vielzahl von Teilregionen (A21) angeordnet ist und mit jeder der Vielzahl von Teilregionen (A21) verbunden ist.

## Revendications

1. Dispositif à émission par la surface à cavité verticale comprenant :
un substrat (11) ;
un premier miroir réfléchissant à film multicouche (12) formé sur le substrat ;
une couche de structure électroluminescente (EMI) formée sur le premier miroir réfléchissant à film multicouche, la couche de structure électroluminescente comportant une couche électroluminescente (14) ; et
un deuxième miroir réfléchissant à film multicouche (19) formé sur la couche de structure électroluminescente, le deuxième miroir réfléchissant à film multicouche constituant un résonateur (OCI) entre le premier miroir réfléchissant à film multicouche et le deuxième miroir réfléchissant à film multicouche, dans lequel
la couche de structure électroluminescente a une région à haute résistance (A1) et une région à faible résistance (A2) ayant une résistance électrique plus faible qu'une résistance électrique de la région à haute résistance,
la région à faible résistance (A2) a une pluralité de régions partielles (A21) agencées en forme d'anneau tout en étant séparées par la région à haute résistance (A1) dans un plan de la couche de structure électroluminescente, et
la région à faible résistance (A2) a une région interne (A20) disposée à l'intérieur de la pluralité de régions partielles (A21) et est connectée à chacune de la pluralité de régions partielles (A21).

2. Dispositif à émission par la surface à cavité verticale selon la revendication 1, dans lequel
la pluralité de régions partielles de la région à faible résistance sont agencées selon une symétrie de rotation dans le plan de la couche de structure électroluminescente.

3. Dispositif à émission par la surface à cavité verticale selon la revendication 1, dans lequel
la région interne de la région à faible résistance est disposée en forme d'anneau.

4. Dispositif à émission par la surface à cavité verticale selon la revendication 3, dans lequel
la région à haute résistance (A1) a une région interne à haute résistance (A12) disposée à l'intérieur de la région interne à faible résistance (A2) et disposée en forme d'anneau, et
la région à faible résistance (A2) a une région centrale (A22) disposée à l'intérieur de la région interne à haute résistance (A12) et entourée par la région interne à haute résistance (A12).

5. Dispositif à émission par la surface à cavité verticale selon l'une quelconque des revendications 1 à 4, dans lequel
la région à haute résistance a une région de circonférence externe (A10) entourant la région à faible résistance, et
le résonateur a une région à faible indice de réfraction (R1, R2, R4) et une région à indice de réfraction élevé (R2, R3), la région à faible indice de réfraction s'étendant entre les premier et deuxième miroirs réfléchissants à film multicouche et correspondant à la région de circonférence externe de la région à haute résistance de la couche de structure électroluminescente, la région à indice de réfraction élevé étant disposée à l'intérieur de la région à indice de réfraction faible et correspondant à la région à faible résistance, la région à indice de réfraction élevé ayant un indice de réfraction équivalent supérieur à un indice de réfraction équivalent de la région à indice de réfraction faible.

6. Dispositif à émission par la surface à cavité verticale selon l'une quelconque des revendications 1 à 5, dans lequel
la couche de structure électroluminescente a une première couche semiconductrice (13) formée sur le premier miroir réfléchissant à film multicouche, la couche électroluminescente formée sur la première couche semiconductrice, et une deuxième couche semiconductrice (15) qui est formée sur la couche électroluminescente et a un type de conductivité opposé à un type de conductivité de la première couche semiconductrice, et
la deuxième couche semiconductrice a une surface supérieure (15A) qui correspond à la région à haute résistance et est recouverte d'une couche isolante (16) et une saillie (15B) qui correspond à la région à faible résistance et saille en forme d'anneau à partir de la surface supérieure pour être exposée à partir de la couche isolante.

7. Dispositif à émission par la surface à cavité verticale selon l'une quelconque des revendications 1 à 5, dans lequel
la couche de structure électroluminescente a une première couche semiconductrice (13) formée sur le premier miroir réfléchissant à film multicouche, la couche électroluminescente formée sur la première couche semiconductrice, et une deuxième couche semiconductrice (15) formée sur la couche électroluminescente, la deuxième couche semiconductrice ayant un type de conductivité opposé à un type de conductivité de la première couche semiconductrice,
la deuxième couche semiconductrice a une région d'implantation d'ions (31A) correspondant à la région à haute résistance et ayant des ions implantés et une région non implantée avec les ions (31B) correspondant à la région à faible résistance.

8. Dispositif à émission par la surface à cavité verticale selon l'une quelconque des revendications 1 à 5, dans lequel
la couche de structure électroluminescente a une première couche semiconductrice (13) formée sur le premier miroir réfléchissant à film multicouche, la couche électroluminescente formée sur la première couche semiconductrice, et une deuxième couche semiconductrice (15) formée sur la couche électroluminescente, la deuxième couche semiconductrice ayant un type de conductivité opposé à un type de conductivité de la première couche semiconductrice, et
la deuxième couche semiconductrice a une région de désactivation (41C) correspondant à la région à haute résistance et ayant des impuretés dans la deuxième couche semiconductrice désactivées et une région correspondant à la région à faible résistance et ayant des impuretés non désactivées.

9. Dispositif à émission par la surface à cavité verticale selon l'une quelconque des revendications 1 à 5, dans lequel
la couche de structure électroluminescente a une première couche semiconductrice (13) formée sur le premier miroir réfléchissant à film multicouche, la couche électroluminescente formée sur la première couche semiconductrice, et une deuxième couche semiconductrice (15) formée sur la couche électroluminescente, la deuxième couche semiconductrice ayant un type de conductivité opposé à un type de conductivité de la première couche semiconductrice, et une couche de jonction tunnel (51) formée sur la deuxième couche semiconductrice, la couche de jonction tunnel correspondant à la région à faible résistance.

10. Dispositif à émission par la surface à cavité verticale comprenant :
un substrat (11) ;
un premier miroir réfléchissant à film multicouche (12) formé sur le substrat ;
une couche de structure électroluminescente (EMI) formée sur le premier miroir réfléchissant à film multicouche, la couche de structure électroluminescente comportant une couche électroluminescente (14) ; et
un deuxième miroir réfléchissant à film multicouche (19) formé sur la couche de structure électroluminescente, le deuxième miroir réfléchissant à film multicouche constituant un résonateur (OC12) entre le premier miroir réfléchissant à film multicouche et le deuxième miroir réfléchissant à film multicouche, dans lequel
la couche de structure électroluminescente a une région à haute résistance (A1) et une région à faible résistance (A2) ayant une résistance électrique inférieure à une résistance électrique de la région à haute résistance,
la région à faible résistance (A2) a une pluralité de régions partielles (A21) agencées en forme d'anneau tout en étant séparées par la région à haute résistance (A1) dans un plan de la couche de structure électroluminescente, et
la région à faible résistance (A2) a une région externe (A20) disposée à l'extérieur de la pluralité de régions partielles (A21) et est connectée à chacune de la pluralité de régions partielles (A21).
